Europäisches Patentamt

European Patent Office

Office européen des brevets

(19)

(11) EP 1 191 692 A1

## (12) EUROPEAN PATENT APPLICATION
published in accordance with Art. 158(3) EPC

(43) Date of publication:
27.03.2002 Bulletin 2002/13

(51) Int Cl.⁷: **H03K 17/08**, H01L 27/04,
H01L 29/78

(21) Application number: 00905360.4

(22) Date of filing: 25.02.2000

(86) International application number:
PCT/JP00/01116

(87) International publication number:
WO 01/63765 (30.08.2001 Gazette 2001/35)

(84) Designated Contracting States:
AT BE CH CY DE DK ES FI FR GB GR IE IT LI LU
MC NL PT SE

(71) Applicant: MITSUBISHI DENKI KABUSHIKI
KAISHA
Tokyo 100-8310 (JP)

(72) Inventors:
• TANAKA, Takeshi,
Mitsubishi Denki Kabushiki Kaisha
Tokyo 100-8310 (JP)

• MASUNAGA, Hiroshi, Mitsubishi Denki KK
Tokyo 100-8310 (JP)

(74) Representative: Mounteney, Simon James et al
MARKS & CLERK,
57-60 Lincoln's Inn Fields
London WC2A 3LS (GB)

### (54) POWER MODULE

(57)     There is provided a power module which has a self arc-suppression type semiconductor device such as an IGBT and a function for protecting the above semiconductor device in order to, in particular, prevent an improper detection of an overcurrent in the IGBT. A resistance value (R3) of the resistor (11) is determined taking into consideration the amount of an abrupt change of a sense emitter current (IS). Also, a time constant (C3 x R3) is determined based on the capacitance (C3) of the capacitor (10) such that it is equal to an attenuation time constant after an abrupt rise of the sense emitter current (IS). Thus, the improper detection of the overcurrent due to the abrupt rise of the sense emitter current (IS) can be prevented.

FIG.   1

EP 1 191 692 A1

## Description

TECHNICAL FIELD

The present invention relates to a power module (hereinafter referred to as an intelligent power module) which has a self arc-suppression type semiconductor device such as an insulated gate bipolar transistor (hereinafter referred to as an IGBT) and a function for protecting the above semiconductor device.

BACKGROUND ART

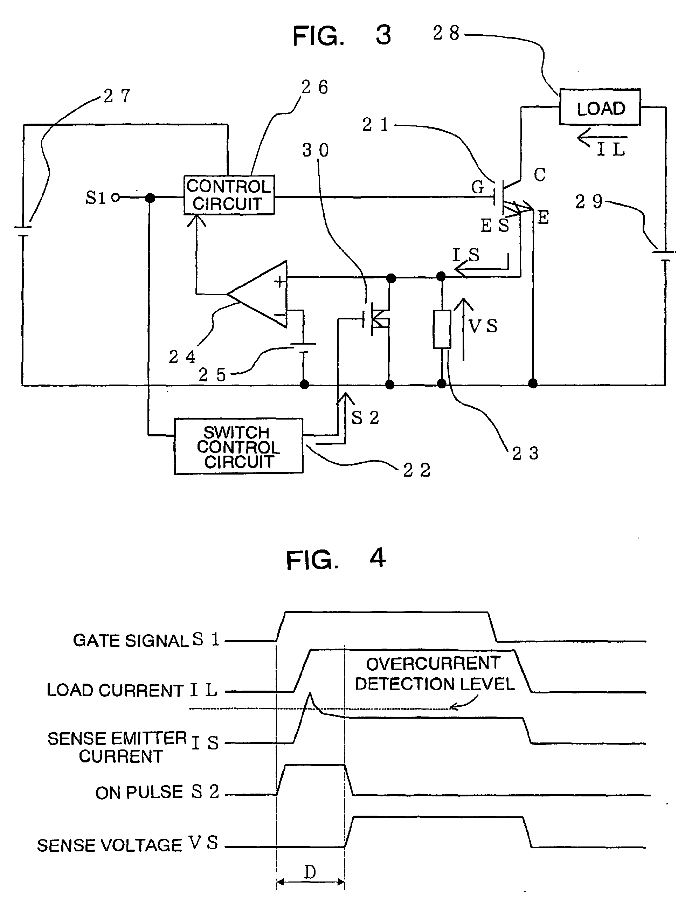

Generally, a sense emitter current IS in the IGBT having a sense emitter ES has a characteristic that it abruptly rises to exceed an actual main circuit current at the turning on and off of the IGBT. In addition, an overcurrent in the IGBT is detected by converting the sense emitter current IS that has been detected into a voltage, and then comparing the converted voltage with a reference voltage corresponding to an overcurrent value. Therefore, a current which is larger than the actual main circuit current IL is detected due to the abrupt rise of the above sense emitter current IS. Thus, there is a problem in that, even if the actual main circuit current IL does not reach an overcurrent level, the overcurrent is improperly detected. As a method of solving this problem, there is a conventional example as shown in Fig. 3.

Fig. 3 shows a conventional intelligent power module disclosed in, for example, Japanese Patent Application Laid-open No. Hei 5-276761 and Fig. 4 is a waveform diagram explaining its operation. In Fig. 3, reference numeral 21 denotes an IGBT, 30 denotes a MOS FET which is turned on for a predetermined period at the turning on of the IGBT 21, 22 denotes a switch control circuit for controlling the MOSFET 30, 23 denotes a resistor for converting the sense emitter current IS into a sense voltage VS, 24 denotes a comparator for comparing the detected sense voltage VS with a reference voltage to be set, 25 denotes the reference voltage corresponding to an overcurrent in the IGBT 21, 26 denotes a control circuit for controlling the turning on and off of the IGBT 21, 27 denotes a control circuit direct current power source, 28 denotes a load composing a main circuit of the IGBT 21, and 29 denotes a main circuit power source.

In Figs. 3 and 4, when a gate signal S1 is inputted to the control circuit 26, the IGBT 21 is turned on and then the main circuit current IL flows from the main circuit power source 29 into the IGBT 21 through a load 28. At this time, the sense emitter current IS in the IGBT 21 transiently rises abruptly. When the sense emitter current IS abruptly rises, a value higher than the actual main circuit current IL is detected. Therefore, even in the case where the main circuit current IL does not reach an overcurrent level, when this current that has abruptly risen exceeds an overcurrent detection level set by the comparator 24, which corresponds to the reference voltage 25, the overcurrent is improperly detected. Thus, during a period D in which the sense emitter current IS abruptly rises, the MOSFET 30 is turned on by the switch control circuit 22 so that the abrupt rise of the sense emitter current IS is not detected. After the period D has elapsed, the MOSFET 30 is turned off and then the sense emitter current IS is converted into the sense voltage VS through the resistor 23 to detect the overcurrent.

Since this conventional example is constructed as above, the switch control circuit 22, the MOSFET 30, and the like are required. Thus, there is a problem in that a circuit structure is complicated. In addition, the sense emitter current is neglected for a predetermined period (D). Therefore, in the case where a short-circuit current is risen at a rapid velocity (di/dt) immediately after the turning on of the IGBT 21, for example, in the case where the IGBT 21 is turned on with a short-circuit state of the load 28, when the MOSFET 30 is turned off and the detection of the sense emitter current is started, the main circuit current IL has already become a value that exceeds a turning off limit of the IGBT 21. Thus, there is a problem in that, even if the short-circuit of the load and an arm short-circuit in an inverter device are made, the IGBT 21 cannot be protected.

DISCLOSURE OF INVENTION

The present invention has been made to solve the above problems, an object of the present invention is therefore to provide a power module in which the improper detection of the overcurrent can be prevented by using a simple circuit structure.

According to the present invention, there is provided a power module including: a self arc-suppression type semiconductor device having a collector, an emitter, and a current detecting emitter; and an overcurrent detection circuit for detecting a detection current flowing into the current detecting emitter to detect an overcurrent flowing between the collector and the emitter in the self arc-suppression type semiconductor device,

wherein the overcurrent detection circuit, a resistor for converting the detection current into a voltage and a series body are provided between the emitter and the current detecting emitter in the self arc-suppression type semiconductor device and connected in parallel with each other, and the series body has a capacitor for absorbing an abrupt rise of the detection current and a resistor for decreasing a detection impedance during a period in which the detection current abruptly rises. Thus, an improper detection of the overcurrent can be prevented using a simple circuit structure.

BRIEF DESCRIPTION OF DRAWINGS

Fig. 1 is a main part circuit diagram indicating an intelligent power module according to Embodiment 1 of the present invention.

Fig. 2 is a waveform diagram of a gate signal S1, a load current IL, a sense emitter current IS, a by-pass current IS1, and a sense voltage VS in the case where an IGBT in Fig. 1 with a tuming off state is turned on.

Fig. 3 is a main part circuit diagram indicating a conventional intelligent power module.

Fig. 4 is a waveform diagram of the gate signal S1, the load current IL, the sense emitter current IS, an on pulse S2, and the sense voltage VS in the case where an IGBT in Fig. 3 with a turning off state is turned on.

BEST MODE FOR CARRYING OUT THE INVENTION

The present invention will be described in details with reference to the accompanying drawings.

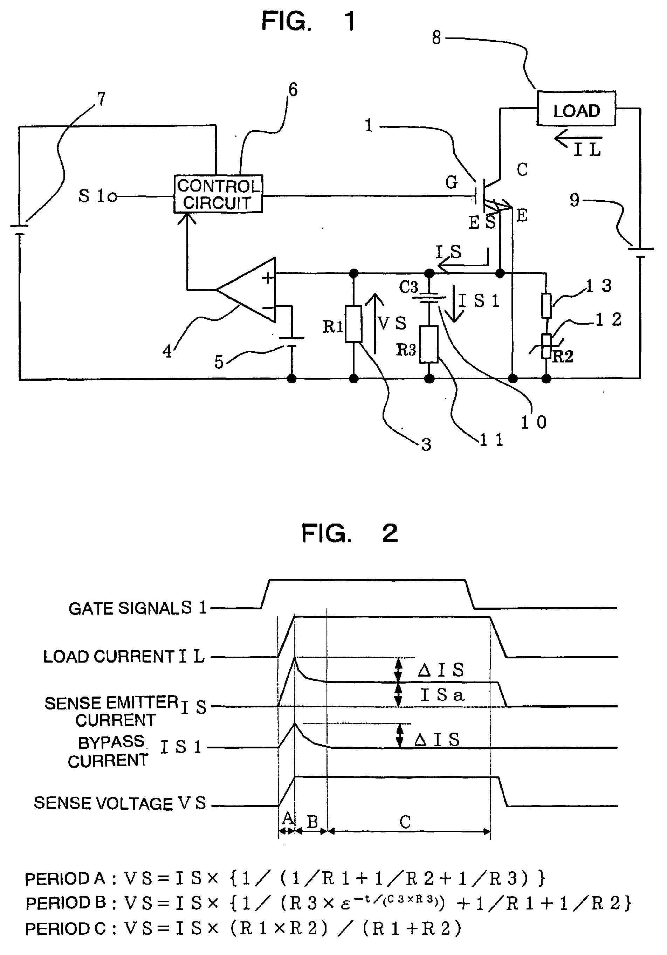

Fig. 1 is a main part circuit diagram indicating an intelligent power module according to Embodiment 1 of the present invention and Fig. 2 is a waveform diagram explaining its operation. In Fig. 1, reference numeral 1 denotes an IGBT, 3 denotes a resistor (resistance value is given as R1) for converting a sense emitter current IS into a sense voltage VS, 4 denotes a comparator for comparing the detected sense voltage VS with a reference voltage to be set, 5 denotes the reference voltage corresponding to an overcurrent in the IGBT 1, 6 denotes a control circuit for controlling the turning on and off of the IGBT 1, 7 denotes a control circuit direct current power source, 8 denotes a load composing a main circuit of the IGBT 1, 9 denotes a main circuit power er source, 10 denotes a capacitor (capacitance is given as C3) for absorbing the abrupt rise of the sense emitter current IS, 11 denotes a resistor (resistance value is given as R3) for decreasing a detection impedance to the sense emitter current IS for a period in which the sense emitter current IS abruptly rises, 12 denotes a thermistor for suppressing a change in an overcurrent detection level due to a temperature (resistance value is given as R2), and 13 denotes a resistor which is connected in series with the thermistor 12.

In Fig. 1, when the gate signal SI is inputted to the control circuit 6, the IGBT 1 is turned on and then the main circuit current IL from the main circuit power source 9 through the load 8 flows from a collector C to an emitter E in the IGBT 1. On the other hand, the sense emitter current IS which is a portion of the main circuit current IL also flows from the collector C to a sense emitter ES. This sense emitter current IS is converted into the sense voltage VS, and then compared with the reference voltage 5, which is set as an overcurrent value, by the comparator 4 to detect the overcurrent.

When the IGBT 1 is turned on, the sense emitter current IS transiently rises abruptly relative to the main circuit current IL that flows from the collector C to the emitter E. Here, a relation between the sense emitter current IS and the sense voltage VS when the IGBT 1 with a turning off state is turned on is described with respect to three separate periods A, B, and C, and its operation will be described using Fig. 2.

First, when the IGBT 1 is being turned off, since the sense emitter current IS is 0, a charge voltage of the capacitor 10 is 0 V.

Next, during the period A immediately after the turning on of the IGBT 1, since the charge voltage of the capacitor 10 is 0 V, the sense current IS flows into a parallel circuit composed of the resistors 3 and 11 and the thermistor 12. Thus, the sense voltage VS is represented by the following equation,

$$VS = IS \times \{1/(1/R1 + 1/R2 + 1/R3)\}.$$

Next, after the sense emitter current IS has abruptly risen, during the period B in which the sense emitter current IS decreases, the capacitor 10 is charged with a by-pass current IS1 of the sense emitter current IS which flows into a series circuit composed of the capacitor 10 and the resistor 11. Therefore, the impedance of the series circuit composed of the capacitor 10 and the resistor 11 is gradually increased in accordance with the time constant (C3 x R3) of the capacitor 10 and the resistor 11. Thus, the sense voltage during the period B changes with the passage of time in accordance with the following equation,

$$VS = IS \times \{1/[(1/R3) \times e^{-t/(c3 \times R3)}$$
$$+ 1/R1 + 1/R2]\}.$$

Next, during the period C in which the sense emitter current IS is kept constant, the charging of the capacitor 10 is completed and the by-pass current IS1 of the sense emitter current IS is OA. Thus, the sense voltage VS during this period C is represented by the following equation,

$$VS = IS \times (R1 \times R2)/(R1 + R2).$$

Therefore, the resistance value R3 of the resistor 11 is determined taking into consideration the amount of an abrupt rise of the sense emitter current IS. Also, the time constant (C3 x R3) is determined based on the capacitance C3 of the capacitor 10 such that it is equal to an attenuation time constant after the abrupt rise of the sense emitter current IS. Thus, the improper detection of the overcurrent due to the abrupt rise of the sense emitter current IS can be prevented.

Note that, the resistance value R3 of the resistor 11 and the capacitance C3 of the capacitor 10 are set as follows.

First, with respect to the resistance value R3,

When $R_A = 1/(1/R1 + 1/R2 + 1/R3)$ and

$$R_c = (R1 \times R2)/(R1 + R2),$$

the resistance value R3 is set such that

$$(Isa + \Delta IS)/Isa = R_C/R_A.$$

Next, with respect to the capacitance C3, the capacitance C3 is set such that the attenuation time constant of the sense emitter current IS during the period B is equal to $C3 \times R3$.

Note that, the thermistor 12 in which the resistance value decreases as the temperature rises is connected in parallel with the resistor 3, and thus the product of the sense emitter current and the detection resistance value is always kept constant. Therefore, a change in an overcurrent detection value due to the temperature can be suppressed. In addition, the resistor 13 which is connected in series with the thermistor 12 is used for a fine adjustment in a temperature correction.

As described above, according to the present invention, despite the simple circuit structure, the improper detection of the overcurrent due to the abrupt rise of the sense emitter current at the turning on and off of the IGBT can be prevented. In addition, since the simple circuit structure is used, it has an advantage over a conventional power module in terms of cost and reliability. Further, the overcurrent due to the abrupt rise of current at di/dt such as in the arm short-circuit, the short-circuit of the load, or the like, which cannot be prevented conventionally, can be detected early by using the capacitor and the resistor connected in series therewith.

Industrial Applicability

As described above, the intelligent power module according to the present invention is suitable to prevent the improper detection of an overcurrent due to the abrupt rise of the sense emitter current in detecting the overcurrent of the sense emitter current in the IGBT.

**Claims**

1. A power module including: a self arc-suppression type semiconductor device having a collector, an emitter, and a current detecting emitter; and an overcurrent detection circuit for detecting a detection current flowing into the current detecting emitter to detect an overcurrent flowing between the collector and the emitter in the self arc-suppression type semiconductor device,

**characterized in that** in the overcurrent detection circuit, a resistor for converting the detection current into a voltage and a series body are provided between the emitter and the current detecting emitter in the self arc-suppression type semiconductor device and connected in parallel with each other, and the series body has a capacitor for absorbing an abrupt rise of the detection current and a resistor for decreasing a detection impedance during a period in which the detection current abruptly rises.

# FIG. 1

# FIG. 2

PERIOD A : $VS = IS \times \{1 / (1/R1 + 1/R2 + 1/R3)\}$

PERIOD B : $VS = IS \times \{1 / (R3 \times \varepsilon^{-t/(C3 \times R3)}) + 1/R1 + 1/R2\}$

PERIOD C : $VS = IS \times (R1 \times R2) / (R1 + R2)$

# FIG. 3

CONTROL CIRCUIT

SWITCH CONTROL CIRCUIT

LOAD

# FIG. 4

GATE SIGNAL S 1

LOAD CURRENT I L

OVERCURRENT DETECTION LEVEL

SENSE EMITTER CURRENT I S

ON PULSE S 2

SENSE VOLTAGE V S

D

**EP 1 191 692 A1**

## INTERNATIONAL SEARCH REPORT

| International application No. |
| --- |
| PCT/JP00/01116 |

A. CLASSIFICATION OF SUBJECT MATTER
    Int.Cl⁷    H03K17/08
               H01L27/04
               H01L29/78
According to International Patent Classification (IPC) or to both national classification and IPC

B. FIELDS SEARCHED

Minimum documentation searched (classification system followed by classification symbols)
    Int.Cl⁷    H03K17/00-70
               H01L27/04
               H01L29/68-78

Documentation searched other than minimum documentation to the extent that such documents are included in the fields searched
Jitsuyo Shinan Koho (Y1, Y2)    1926-2000    Toroku Jitsuyo Shinan Koho(U) 1994-2000
Kokai Jitsuyo Shinan Koho (U)   1971-2000    Jitsuyo Shinan Toroku Koho(Y2)1996-2000

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X | JP, 5-122036, A (Toyoda Automatic Loom Works, Ltd.), 18 May, 1993 (18.05.93), Par. Nos. [0004] to [0005]   (Family: none) | 1 |
| A | JP, 6-152354, A (Fuji Electric Co., Ltd.), 31 May, 1994 (31.05.94), Par. No. [0025]   (Family: none) | 1 |
| A | JP, 9-64707, A (Matsushita Electronic Corporation), 07 March, 1997 (07.03.97), Par. No. [0002]   (Family: none) | 1 |

☐ Further documents are listed in the continuation of Box C.     ☐ See patent family annex.

| | | |
| --- | --- | --- |
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "E" | earlier document but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
| --- | --- |
| 23 May, 2000 (23.05.00) | 06 June, 2000 (06.06.00) |

| Name and mailing address of the ISA/ | Authorized officer |
| --- | --- |
| Japanese Patent Office | |
| Facsimile No. | Telephone No. |

Form PCT/ISA/210 (second sheet) (July 1992)